# EUROPEAN PATENT APPLICATION

(11) **EP 4 701 380 A1**
(43) Date of publication of application: **25.02.2026**
(21) Application number: 25191751.4
(22) Date of filing: 25.07.2025
(51) Int. Cl.: H10K 59/122, H10K 59/80

(54) **DISPLAY PANEL AND ELECTRONIC APPARATUS INCLUDING THE DISPLAY PANEL**

(30) Priority: 21.08.2024 KR 20240112216; 06.01.2025 KR 20250001761
(71) Applicant: Samsung Display Co., Ltd., Yongin-si, Gyeonggi-do 17113 (KR)
(72) Inventor: JANG, Keunho, Giheung-Gu, Yongin-si, Gyeonggi-Do (KR); KANG, Namwook, Giheung-Gu, Yongin-si, Gyeonggi-Do (KR); KIM, Wonjong, Giheung-Gu, Yongin-si, Gyeonggi-Do (KR); KIM, Jae-Ho, Giheung-Gu, Yongin-si, Gyeonggi-Do (KR); KIM, Hyoeng-Ki, Giheung-Gu, Yongin-si, Gyeonggi-Do (KR); PARK, Joongyong, Giheung-gu, Yongin-si, Gyeonggi-do (KR); SHIN, Hyuneok, Giheung-gu, Yongin-si, Gyeonggi-do (KR); LEE, Dongmin, Giheung-gu, Yongin-si, Gyeonggi-do (KR); LEE, You Jong, Giheung-Gu, Yongin-si, Gyeonggi-Do (KR); JEONG, Samtae, Giheung-Gu, Yongin-si, Gyeonggi-Do (KR)
(74) Representative: Dr. Weitzel & Partner

(57) **Abstract**

A display panel includes an insulating layer, a pixel defining film which is arranged on the insulating layer and in which an opening is defined, a pixel electrode having at least a portion exposed through the opening, an emission layer arranged on the pixel electrode, an electron control layer arranged on the emission layer, and a transparent electrode arranged on the electron control layer and including gallium. The display panel further includes at least one of a metal oxide layer arranged on the transparent electrode, or an auxiliary metal layer arranged on the pixel defining film.

## Description

The present invention relates to a display panel including a light emitting element, and an electronic apparatus including the display panel.

Recently, organic electroluminescence (electroluminescent) display devices and/or the like have been actively developed and utilized as image display devices. These organic electroluminescence display devices and/or the like include selfemissive light emitting elements in each of which holes and electrons separately injected from a first electrode and a second electrode are recombined in emission layer(s). This recombination causes the light emitting material(s) in the emission layer(s) to emit light, thereby implementing (creating) a display. Significant research and development efforts have been focused on improving the display quality of these display devices.

The present invention is defined by the features of claim 1. The dependent claims and the description provide preferred embodiments of the invention.

One or more aspects of embodiments of the present invention are directed toward a display panel that exhibits enhanced (e.g., excellent or suitable) processibility and enhanced (e.g., excellent, suitable, or improved) display quality, and an electronic apparatus that includes the display panel. Additional aspects will be set forth in part in the description which follows and, in part, will be apparent from the description, or may be learned by practice of the presented embodiments.

According to the present invention, a display panel includes an insulating layer, a pixel defining film on (e.g., arranged on) the insulating layer and including an opening, a pixel electrode having at least a portion exposed through the opening, an emission layer on (e.g., arranged on) the pixel electrode, and a transparent electrode on (e.g., arranged on) the emission layer and including gallium. The display panel further includes at least one of a metal oxide layer on (e.g., arranged on) the transparent electrode, or an auxiliary metal layer on (e.g., arranged on) the pixel defining film.

In one or more embodiments, the transparent electrode may include indium gallium zinc oxide, which includes gallium.

In one or more embodiments, the display panel may further include an electron control layer on (e.g., arranged on) the emission layer, and the transparent electrode may be directly on (e.g., arranged on) the electron control layer.

In one or more embodiments, the auxiliary metal layer may be between (e.g., arranged between) the electron control layer and the transparent electrode.

In one or more embodiments, the electron control layer may include at least one of Li₂O, BaO, MgO, a halogenated metal (e.g., a metal halide), a lanthanum group metal (e.g., a lanthanide metal), lithium (Li), magnesium (Mg), silver (Ag), or (8-hydroxyquinolinato)lithium (Liq).

In one or more embodiments, the metal oxide layer may include indium zinc oxide (IZO) or indium tin oxide (ITO).

In one or more embodiments, the metal oxide layer may overlap the pixel defining film and the pixel electrode.

In one or more embodiments, a first thickness of the transparent electrode may be larger than a second thickness of the metal oxide layer.

In one or more embodiments, the first thickness of the transparent electrode may be about 40 nanometer (nm) (400 angstroms (Å)) to about 70 nm (700 Å).

In one or more embodiments, the second thickness of the metal oxide layer may be about 10 nm (100 Å) to about 50 nm (500 Å).

In one or more embodiments, the auxiliary metal layer may include at least one of aluminum (Al), titanium (Ti), copper (Cu), molybdenum (Mo), tantalum (Ta), niobium (Nb), vanadium (V), silver (Ag), magnesium (Mg), platinum (Pt), palladium (Pd), gold (Au), nickel (Ni), neodymium (Nd), iridium (Ir), chromium (Cr), lithium (Li), calcium (Ca), ytterbium (Yb), or tungsten (W).

In one or more embodiments, the auxiliary metal layer may be in electrical contact with the transparent electrode.

In one or more embodiments, the auxiliary metal layer may be between (e.g., arranged between) the pixel defining film and the transparent electrode.

In one or more embodiments, the auxiliary metal layer may not overlap the pixel electrode.

In one or more embodiments, on a cross-section parallel to a thickness direction, the auxiliary metal layer may include a side surface inclined with respect to the thickness direction, and a top surface extending from the side surface and normal (e.g., perpendicular) to the thickness direction.

In one or more embodiments, on a cross-section parallel to a thickness direction, the auxiliary metal layer may include a first portion which includes a first side surface inclined with respect to the thickness direction, and a second portion which includes a second side surface parallel to the thickness direction and is arranged on the first portion, and the second side surface may be arranged outward from the first side surface.

In one or more embodiments, the transparent electrode may be a single layer.

In one or more embodiments, the insulating layer may be a planarization layer.

According to one or more embodiments of the present invention, an electronic apparatus includes a display panel including a module area, and an electronic module arranged to correspond to the module area. The display panel includes an insulating layer, a pixel defining film on (e.g., arranged on) the insulating layer and including an opening, a pixel electrode having at least a portion exposed through the opening, an emission layer on (e.g., arranged on) the pixel electrode, and a transparent electrode on (e.g., arranged on) the emission layer and including gallium. The display panel further includes at least one of a metal oxide layer on (e.g., arranged on) the transparent electrode, or an auxiliary metal layer on (e.g., arranged on) the pixel defining film.

In one or more embodiments, the transparent electrode may include indium gallium zinc oxide, which includes gallium.

In one or more embodiments, the display panel may further include an electron control layer on (e.g., arranged on) the emission layer and including at least one of Li₂O, BaO, MgO, a halogenated metal (e.g., a metal halide), a lanthanum group metal (e.g., a lanthanide metal), Li, Mg, Ag, or (8-hydroxyquinolinato)lithium, and the transparent electrode may be directly arranged on the electron control layer.

In one or more embodiments, the metal oxide layer may include indium zinc oxide (IZO) or indium tin oxide (ITO).

In one or more embodiments, a first thickness of the transparent electrode may be larger than a second thickness of the metal oxide layer. The first thickness of the transparent electrode may be about 40 nm (400 Å) to about 70 nm (700 Å), and the second thickness of the metal oxide layer may be about 10 nm (100 Å) to about 50 nm (500 Å).

In one or more embodiments, the auxiliary metal layer may be in electrical contact with the transparent electrode and include at least one of aluminum (Al), titanium (Ti), copper (Cu), molybdenum (Mo), tantalum (Ta), niobium (Nb), vanadium (V), silver (Ag), magnesium (Mg), platinum (Pt), palladium (Pd), gold (Au), nickel (Ni), neodymium (Nd), iridium (Ir), chromium (Cr), lithium (Li), calcium (Ca), ytterbium (Yb), or tungsten (W).

According to one or more embodiments of the present invention, an electronic apparatus includes a processor and a display panel and has improved or desired display quality. The display panel includes an insulating layer, a pixel defining film on (e.g., arranged on) the insulating layer and including an opening, a pixel electrode having at least a portion exposed through the opening, an emission layer on (e.g., arranged on) the pixel electrode, and a transparent electrode on (e.g., arranged on) the emission layer and including gallium. The display panel further includes at least one of a metal oxide layer on (e.g., arranged on) the transparent electrode, or an auxiliary metal layer on (e.g., arranged on) the pixel defining film.

In one or more embodiments, the transparent electrode may include indium gallium zinc oxide, which includes gallium.

In one or more embodiments, the metal oxide layer may include indium zinc oxide (IZO) or indium tin oxide (ITO).

In one or more embodiments, the auxiliary metal layer may be in electrical contact with the transparent electrode.

The accompanying drawings are included to provide a further understanding of the invention, and are incorporated in and constitute a part of this disclosure. The drawings illustrate embodiments of the invention and, together with the description, serve to explain principles of the invention. The above and other objects and features of the present invention will become apparent by describing in example embodiments thereof with reference to the accompanying drawings. In the drawings:
FIG. 1 is a perspective view illustrating an electronic apparatus according to one or more embodiments of the present invention;
FIG. 2 is an exploded perspective view illustrating an electronic apparatus according to one or more embodiments of the present invention;
FIG. 3 is a cross-sectional view illustrating a portion corresponding to the line I-I' in FIG. 2 according to one or more embodiments of the present invention;
FIG. 4 is a plan view illustrating a portion of an electronic apparatus according to one or more embodiments of the present invention;
FIG. 5 is a cross-sectional view illustrating a portion of an electronic apparatus according to one or more embodiments of the present invention;
FIG. 6A is an enlarged cross-sectional view illustrating area XX' in FIG. 5 according to one or more embodiments of the present invention;
FIG. 6B is a cross-sectional view illustrating a portion of an electronic apparatus according to one or more embodiments of the present invention;
FIG. 7 is a cross-sectional view illustrating a portion of an electronic apparatus according to one or more embodiments of the present invention;
FIG. 8 is a cross-sectional view illustrating a portion of an electronic apparatus according to one or more embodiments of the present invention;
FIG. 9 is a cross-sectional view illustrating a portion of an electronic apparatus according to one or more embodiments of the present invention;
FIG. 10 is a cross-sectional view illustrating a portion of an electronic apparatus according to one or more embodiments of the present invention;
FIG. 11 is a cross-sectional view illustrating a portion of an electronic apparatus according to one or more embodiments of the present invention;
FIG. 12 is a block diagram of an electronic apparatus according to one or more embodiments of the present invention;
FIG. 13 is a view illustrating electronic apparatuses according to one or more suitable embodiments of the present invention;
FIG. 14A is a graph showing results of measuring the number of particles in samples of the present invention; and
FIG. 14B is a graph showing distributions of the number of the particles measured in the samples in FIG. 14A.

The present invention may be modified and implemented in one or more suitable forms, and particular embodiments thereof will be illustrated in the drawings and described herein in more detail. The invention should not be construed as limited to one or more embodiments set forth herein. Rather, these embodiments are provided so that this disclosure will be thorough and complete, and will fully convey the scope of the invention to those skilled in the art.

In this disclosure, it will be understood that if (e.g., when) an element (or a region, a layer, a portion, and/or the like) is referred to as being "on", "connected to" or "coupled to" another element, it may be directly arranged on, connected to, or coupled to the other element, or one or more intervening elements may be arranged therebetween. In contrast, "directly on" may refer to that there are no additional intervening elements or layers between the element or layer and the other element or layer. In addition, if (e.g., when) a layer, a film, a region, a plate, and/or the like is referred to as being "under" or "below" another part, it may be "directly under" the other part, or one or more intervening layers may be present therebetween. Also, if (e.g., when) an element is referred to as being arranged "on" another element, it may be arranged under the another element.

Like reference numerals or reference characters or symbols refer to like elements throughout the disclosure, and duplicative descriptions thereof may not be provided for conciseness. In the drawings, the thickness, ratio, and size of elements may be exaggerated for effectively describing the technical contents. The term "and/or" or "or" may include one or more combinations which may be defined by relevant elements.

It will be understood that, although the terms "first", "second", and/or the like may be used herein to describe one or more suitable elements, the elements are not to be limited by these terms. These terms are only used to distinguish one element from another element. For instance, a first element, component, region, layer, or section discussed herein could be termed a second element, component, region, layer, or section without departing from the scope of the invention. Similarly, a second element, component, region, layer or section could be termed a first element, component, region, layer or section. In this disclosure, the singular expressions "a", "an" and "the" are intended to include the plural forms as well, unless the context clearly indicates otherwise.

In addition, the terms "below", "under", "on the lower side", "above", "over", "on the upper side", and/or the like may be used to describe the relationships between the elements illustrated in the drawings. These terms are relative concepts and are described on the basis of the directions indicated in the drawings.

It will be further understood that the terms "comprise(s)/comprising," and/or "include(s)/including," and/or "has(have)/having," if (e.g., when) used in this disclosure, specify the presence of stated features, numbers, steps, operations, elements, components, and/or one or more (e.g., any suitable) combinations thereof, but do not preclude the possibility of the presence or addition of one or more other features, numbers, steps, operations, elements, components, and/or one or more (e.g., any suitable) combinations thereof. Additionally, the terms "comprise(s)/comprising," "include(s)/including," "has(have)/having", or other similar terms include or support the terms "consisting of" and "consisting essentially of," indicating the presence of stated features, numbers, steps, operations, elements, parts, and/or components, without or essentially without the presence of other features, numbers, steps, operations, elements, parts, components, and/or groups thereof.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

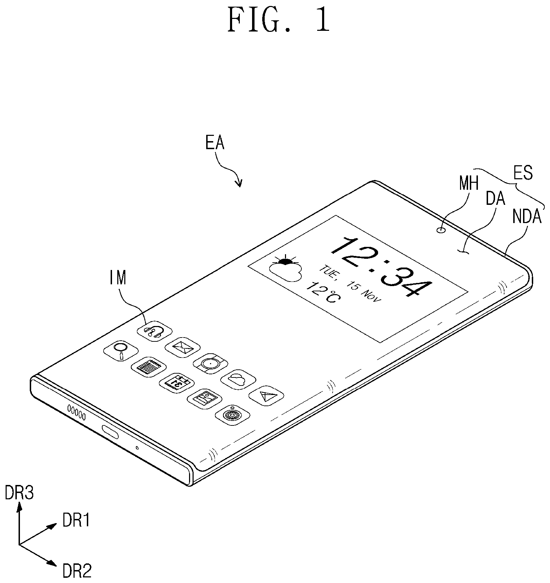

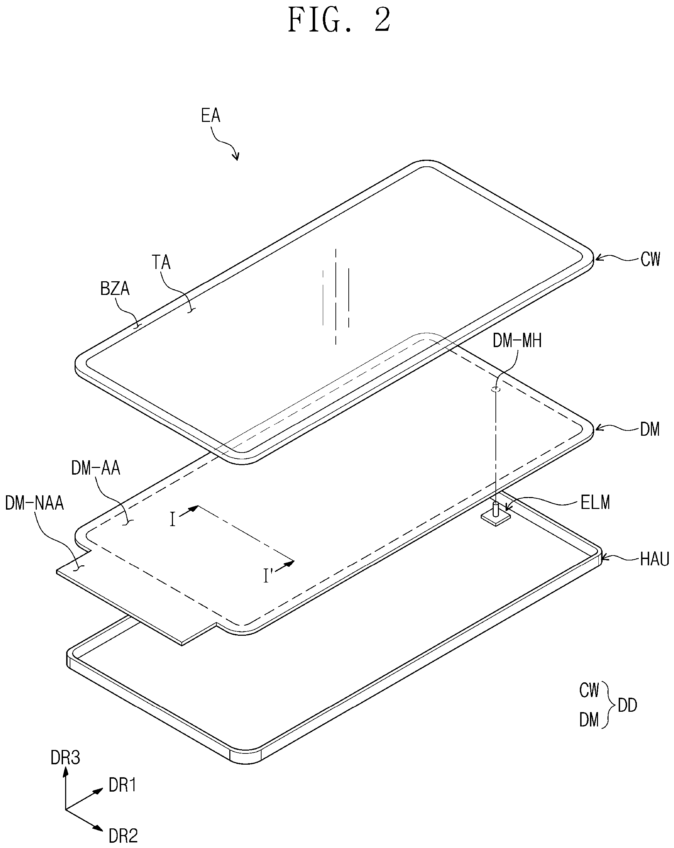

Hereinafter, a display panel and an electronic apparatus including the display panel according to one or more embodiments of the invention will be described with reference to the accompanying drawings. FIG. 1 is a perspective view illustrating an electronic apparatus according to one or more embodiments of present invention. FIG. 2 is an exploded perspective view of an electronic apparatus according to one or more embodiments of the present invention.

An electronic apparatus EA according to one or more embodiments illustrated in FIG. 1 may be an apparatus that is activated in response to an electrical signal. For example, the electronic apparatus EA may be a personal computer, a notebook computer, a personal digital assistant, a game console, a portable electronic device, a television, a monitor, an outdoor billboard, a vehicle navigation device, or a wearable device, but embodiments of the present invention are not limited thereto. FIG. 1 illustrates a smartphone as an example of the electronic apparatus EA.

The electronic apparatus EA may include a display surface ES defined by a first directional axis DR1 and a second directional axis DR2 crossing the first directional axis DR1. The electronic apparatus EA may provide an image IM for a user through the display surface ES. The electronic apparatus EA may display the image IM toward a direction of a third directional axis DR3 on the display surface ES parallel to each of the first directional axis DR1 and the second directional axis DR2 (e.g., parallel to a plane defined by the first directional axis DR1 and the second directional axis DR2). The image IM may include a dynamic image and/or a still image.

Directions indicated by the first to third directional axes DR1, DR2 and DR3 used herein are relative concepts and may be changed to other directions. The directions indicated by the first to third directional axes DR1, DR2 and DR3 may be also referred to as first to third directions, and may be designated by like reference numbers or reference characters or symbols.

In the present invention, the first directional axis DR1 and the second directional axis DR2 normally (e.g., perpendicular) cross each other, and the third directional axis DR3 may be a normal direction to a plane defined by the first directional axis DR1 and the second directional axis DR2. A thickness direction of the electronic apparatus EA may be a direction parallel to the third directional axis DR3. The thickness direction of the electronic apparatus EA may be designated by the reference number or reference characters or symbol designating the third directional axis DR3. A front surface (or top surface) and a rear surface (or bottom surface) may oppose each other with respect to the third directional axis DR3, and a normal direction to each of the front surface (or top surface) and the rear surface (or bottom surface) may be parallel to the third directional axis DR3. The front surface (or top surface) indicates a surface adjacent to the display surface ES, and the rear surface (or bottom surface) indicates a surface spaced and/or apart (e.g., spaced apart or separated) from the display surface ES. An upper side indicates a direction that is closer to the display surface ES, and a lower side indicates a direction that is away from the display surface ES.

As used herein, a cross-section indicates a surface parallel to the thickness direction DR3. A plane indicates a surface which is normal (e.g., perpendicular) to the thickness direction DR3 and parallel to a plane defined by the first directional axis DR1 and the second directional axis DR2. In addition, the term "on a plane" or "in plan view" may refer to a state, in which it is viewed from the third directional DR3. And the term "on a cross-section" or "in cross-sectional view" may refer to a state, in which it is viewed from a direction normal to the third directional DR3.

The electronic apparatus EA may sense an external input applied from the outside. The external input may include one or more suitable types (kinds) of inputs provided from the outside of the electronic apparatus EA. For example, the external input may include not only a touch by part of the body of a user, such as a user's hand, but also an external input (e.g., hovering) applied by approaching the electronic apparatus EA or being adjacent thereto by a certain distance. In addition, the external input may also include one or more suitable types (kinds) such as force, pressure, temperature, and light.

The display surface ES may include a display area DA, a non-display area NDA, and a sub-area MH. The display area DA may be an area that is activated in response to an electrical signal. The display area DA may be an area on which the image IM is displayed, and which may sense one or more suitable types (kinds) of external inputs.

The display area DA may include a plane defined by the first directional axis DR1 and the second directional axis DR2. In one or more embodiments, the display area DA may include a curved surface bent from at least one side of the plane defined by the first directional axis DR1 and the second directional axis DR2. The electronic apparatus EA according to one or more embodiments illustrated in FIG. 1 includes two curved surfaces bent respectively from opposite sides of the plane defined by the first directional axis DR1 and the second directional axis DR2. However, this is merely an example, and a shape of the display area DA is not limited thereto. For example, in one or more embodiments, the display area DA may include only the plane defined by the first directional axis DR1 and the second directional axis DR2. In one or more embodiments, the display area DA may further include two or more curved surfaces bent respectively from at least two sides of the plane defined by the first directional axis DR1 and the second directional axis DR2, for example, four curved surfaces bent respectively from four sides.

The electronic apparatus EA according to one or more embodiments may be flexible. The term "flexible" indicates a characteristic of being capable of bending (e.g., folding, twisting, and/or rolling), and may include all from a fully folded structure to a structure capable of bending at the level of several nanometers. For example, in one or more embodiments, the electronic apparatus EA may be a rigid apparatus. In one or more embodiments, the electronic apparatus EA may be a foldable apparatus.

The non-display area NDA may have a certain color. The non-display area NDA may be an area adjacent to the display area DA. The non-display area NDA may be around (e.g., surround) the display area DA. Accordingly, the shape of the display area DA may be substantially defined by the non-display area NDA. However, this is illustrated as an example, and the non-display area NDA may be arranged adjacent to only one side of the display area DA, or may not be provided. The display area DA may be provided in one or more suitable shapes, and embodiments of the present invention are not limited thereto.

The sub-area MH may sense an external object received through the display surface ES, or provide the outside with a sound signal such as voice, through the display surface ES. An optical signal such as visible light or infrared light may travel to the sub-area MH.

In one or more embodiments, the sub-area MH may be arranged within the display area DA. However, this is merely an example, and an arrangement of the sub-area MH is not limited thereto. For example, in one or more embodiments, the sub-area MH may be surrounded by the non-display area NDA. In one or more embodiments, the sub-area MH may be surrounded by the display area DA and the non-display area NDA. Although one sub-area MH is illustrated in FIG. 1, in one or more embodiments, the sub-area MH may be provided in plurality.

Various electronic modules ELM (see FIG. 2) may be arranged to correspond to the sub-area MH. For example, the electronic modules ELM (see FIG. 2) may include at least one of a camera, a speaker, a light detecting sensor, or a heat detecting sensor. In one or more embodiments, the electronic apparatus EA may include the electronic module ELM (see FIG. 2) which photographs an external image by using visible light passing through the sub-area MH, or determines approach of an external object by using infrared light. The electronic module ELM (see FIG. 2) may include a plurality of components and is not specifically limited thereto.

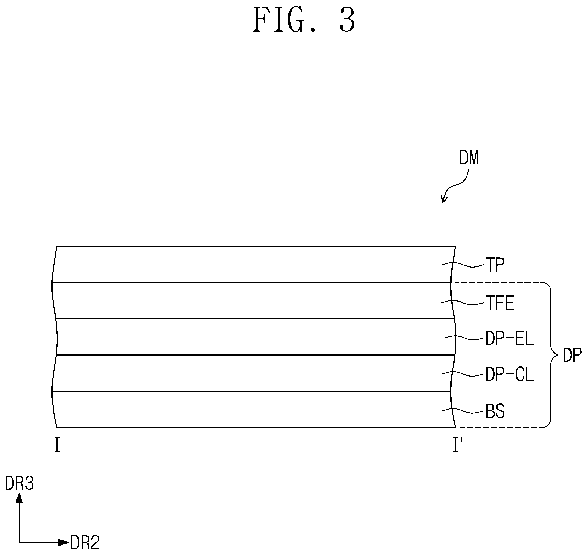

Referring to FIG. 2, the electronic apparatus EA may include a display device DD and the electronic module ELM. The display device DD may include a display module DM and a window member CW arranged on the display module DM. In addition, the electronic apparatus EA may further include a housing HAU in which the display module DM is accommodated. A module area DM-MH may be defined in the display module DM, and the electronic module ELM may be arranged to correspond to the module area DM-MH. For example, the module area DM-MH may be defined in a display panel DP (see FIG. 3) included by the display module DM. The display panel DP (see FIG. 3) will be described later in more detail.

In the electronic apparatus EA illustrated in FIG. 1 and FIG. 2, the window member CW and the housing HAU may be coupled to constitute an outer appearance of the electronic apparatus EA. The housing HAU may be arranged below the display module DM. The housing HAU may include a material having relatively high rigidity. For example, in one or more embodiments, the housing HAU may include a plurality of frames and/or plates, each of which may independently include glass, plastic, or metal. The housing HAU may provide a certain accommodation space. The display module DM may be accommodated in the accommodation space and protected against an external impact.

The display module DM may be activated in response to an electrical signal. The display module DM may be activated to display the image IM (see FIG. 1) on the display area DA (see FIG. 1) of the electronic apparatus EA. An active area DM-AA, a peripheral area DM-NAA, and the module area DM-MH may be defined in the display module DM.

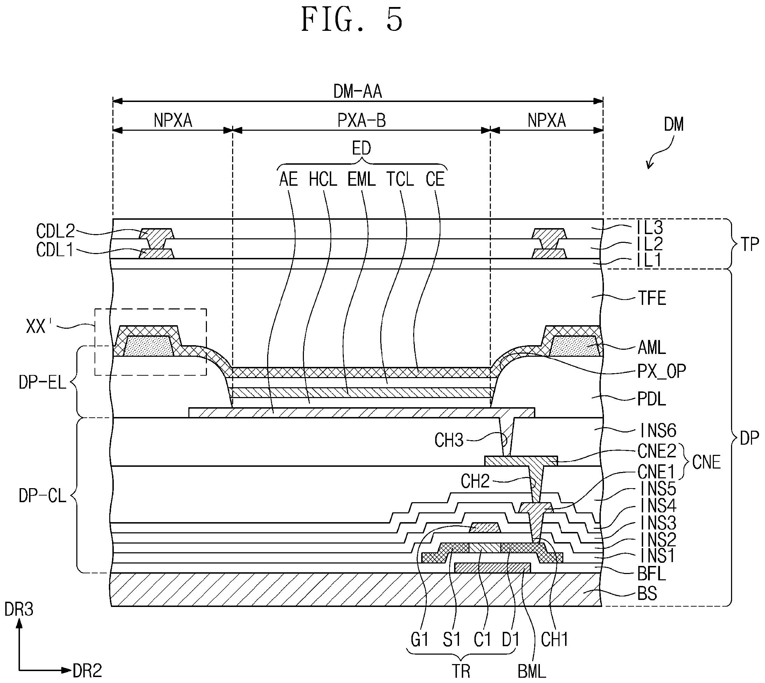

The active area DM-AA may be an area that is activated in response to an electrical signal. A pixel may be arranged in the active area DM-AA. The pixel may include a transistor TR (see FIG. 5) and a light emitting element ED (see FIG. 5), each of which will be described in more detail later. The peripheral area DM-NAA may be an area that is arranged adjacent to at least one side of the active area DM-AA. A circuit, a line, and/or the like for driving the active area DM-AA may be arranged in the peripheral area DM-NAA.

The module area DM-MH may correspond to the sub-area MH illustrated in FIG. 1. An optical signal such as visible light or infrared light may travel to the module area DM-MH. In one or more embodiments, the module area DM-MH may be arranged within the active area DM-AA. In one or more embodiments, the module area DM-MH may be surrounded by the peripheral area DM-NAA or surrounded by the active area DM-AA and the peripheral area DM-NAA.

The electronic module ELM may be an electronic part that outputs or receives the optical signal. The electronic module ELM may include a camera module and/or a proximity sensor. The camera module may photograph an external image through the module area DM-MH. The electronic apparatus EA may further include a power module, a built-in module, and/or an external module. The power module may include a battery which charges a power voltage. The battery may include a nonrechargeable primary battery, a rechargeable secondary battery, or a fuel battery. The built-in module may include an antenna module, a sound output module, and/or the like. The external module may include a light module, a communication module, and/or the like.

In one or more embodiments, the display device DD may further include an optical layer arranged between the display module DM and the window member CW. The optical layer may be provided on the display module DM through a substantially continuous process. The optical layer may include a polarizing plate or include a color filter layer. For example, in one or more embodiments, the optical layer may include at least one of a retarder, a polarizer, a polarizing film, or a polarizing filter. In one or more embodiments, the optical layer may include a plurality of color filters arranged in a certain arrangement. For example, the color filters may be arranged according to light of emissive colors of pixels. In addition, the optical layer may further include a black matrix adjacent to the color filters.

The window member CW may include a transmission area TA and a bezel area BZA. The transmission area TA may overlap at least a portion of the active area DM-AA of the display module DM. The transmission area TA may be an optically transparent area. The image IM (see FIG. 1) may be provided for a user through the transmission area TA.

The bezel area BZA may be an area having a relatively lower light transmittance than the transmission area TA. The bezel area BZA may define a shape of the transmission area TA. The bezel area BZA may be adjacent to the transmission area TA and be around (e.g., surround) the transmission area TA.

The bezel area BZA may have a certain color. The bezel area BZA may cover the peripheral area DM-NAA of the display module DM and prevent or reduce the peripheral area DM-NAA from being visible from the outside. However, embodiments of the present invention are not limited thereto, for example, in one or more embodiments, the bezel area BZA may be arranged adjacent to only one side of the transmission area TA, or may have at least a portion not provided.

FIG. 3 is a cross-sectional view illustrating a portion corresponding to the line I-I' in FIG. 2 according to one or more embodiments of the present invention. FIG. 3 may be a schematic cross-sectional view illustrating a display module DM according to one or more embodiments.

Referring to FIG. 3, the display module DM may include a display panel DP, and an input sensing part TP arranged on the display panel DP. The display panel DP may be a component that substantially generates an image.

The display panel DP may include a base substrate BS, a circuit layer DP-CL, a display element layer DP-EL, and an encapsulation layer TFE which are stacked in sequence. In one or more embodiments, a separate member may be further arranged between two adjacent layers among the base substrate BS, the circuit layer DP-CL, the display element layer DP-EL, and the encapsulation layer TFE.

The base substrate BS may provide a base surface on which the circuit layer DP-CL is arranged. In one or more embodiments, the base substrate BS may be a flexible substrate capable of bending, folding, rolling, and/or the like. The base substrate BS may be a glass substrate, a metal substrate, a polymer substrate, and/or the like. However, embodiments of the present invention are not limited thereto, and the base substrate BS may include an inorganic layer, an organic layer, or a composite material layer.

The circuit layer DP-CL may be arranged on the base substrate BS. The circuit layer DP-CL may include an insulating layer, a semiconductor pattern, a conductive pattern, a signal line, and/or the like. The display element layer DP-EL may be arranged on the circuit layer DP-CL. The display element layer DP-EL may include a light emitting element ED (see FIG. 5) to be described in more detail later. For example, the light emitting element ED (see FIG. 5) may include an organic light emitting material, an inorganic light emitting material, an organic-inorganic light emitting material, a quantum dot, or a quantum rod. For example, in one or more embodiments, the light emitting element ED (see FIG. 5) may include a micro LED or a nano LED.

The encapsulation layer TFE may be arranged on the display element layer DP-EL. The encapsulation layer TFE may protect the display element layer DP-EL from moisture, oxygen, and foreign matter such as dust particles. The encapsulation layer TFE may include at least one inorganic layer. For example, in one or more embodiments, the encapsulation layer TFE may include an inorganic layer, an organic layer, and an inorganic layer, which are stacked in sequence.

The input sensing part TP may be arranged on the display panel DP. In one or more embodiments, the input sensing part TP may be directly arranged on the encapsulation layer TFE. In one or more embodiments, an adhesive member may be arranged between the input sensing part TP and the display panel DP.

In the present invention, if (e.g., when) one component is referred to as being directly arranged/provided/formed on another component, it refers to that a (any) third component is not arranged/provided/formed between the one component and the other component. For example, if (e.g., when) one component is referred to as being "directly arranged/provided/formed" on another component, it refers to that the one component and the other component are in "contact" with each other.

The input sensing part TP may sense an external input to covert the external input into a certain input signal, and provide the input signal to the display panel DP. For example, in one or more embodiments, the input sensing part TP may be a touch sensing part that senses a touch. The input sensing part TP may perceive a direct touch by a user, an indirect touch by a user, a direct touch by an object, an indirect touch by an object, and/or the like.

The input sensing part TP may sense at least one of a position of a touch applied from the outside or an intensity (pressure) of the touch. In one or more embodiments, the input sensing part TP may have one or more suitable structures or include one or more suitable materials, and embodiments of the present invention are not limited thereto. For example, in one or more embodiments, the input sensing part TP may sense an external input using a capacitance method. The display panel DP may receive an input signal from the input sensing part TP and generate an image corresponding to the input signal.

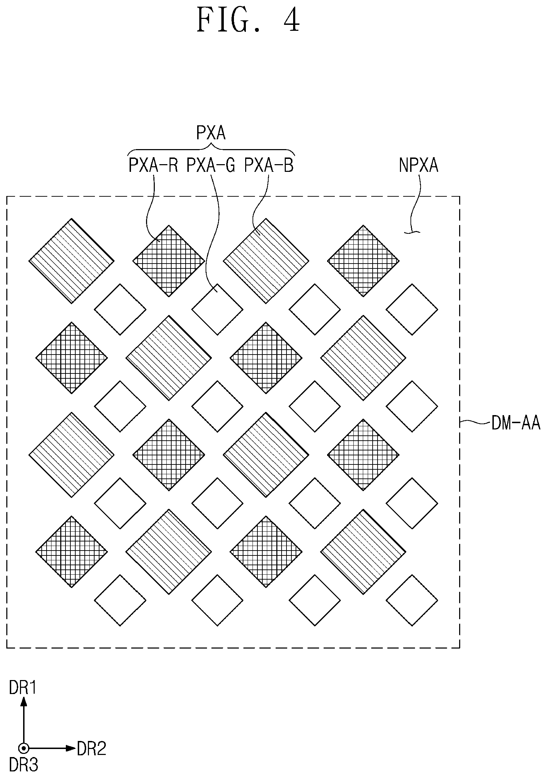

FIG. 4 is an enlarged plan view illustrating a portion of an active area of the display module according to one or more embodiments of present invention. Referring to FIG. 4, an active area DM-AA may include a light emitting area PXA and a light blocking area NPXA. The light blocking area NPXA may be around (e.g., surround) the light emitting area PXA.

The light emitting area PXA may be provided as a plurality of light emitting areas which emit light in different wavelength regions. The light emitting area PXA may include a first light emitting area PXA-B, a second light emitting area PXA-G, and a third light emitting area PXA-R. For example, in one or more embodiments, the first light emitting area PXA-B may be to emit blue light, the second light emitting area PXA-G may be to emit green light, and the third light emitting area PXA-R may be to emit red light. However, embodiments of the present invention are not limited thereto, and the first to third light emitting areas PXA-B, PXA-G and PXA-R may be to emit light of colors other than the blue light, the green light, and the red light.

In one or more embodiments, among the light emitting areas PXA, the first light emitting area PXA-B which is configured to emit the blue light may have the largest surface area, and the second light emitting area PXA-G which is configured to emit the green light may have the smallest surface area. Here, the surface area indicates a surface area on a plane (in plan view). However, this is merely an example, and the surface areas of the first to third light emitting areas PXA-B, PXA-G and PXA-R are not limited thereto.

FIG. 4 illustrates one or more embodiments in which the first light emitting area PXA-B and the third light emitting area PXA-R are alternately arranged in a first row along the second direction DR2, and the second light emitting area PXA-G is arranged in a second row and spaced and/or apart (e.g., spaced apart or separated) from the first light emitting area PXA-B and the third light emitting area PXA-R. However, this is merely an example, and an arrangement of the first to third light emitting areas PXA-B, PXA-G, and PXA-R is not limited thereto. In addition, respective shapes of the first to third light emitting areas PXA-B, PXA-G and PXA-R on a plane are not limited to the illustrated shapes, and may be defined as different shapes from the illustrated shapes.

The light blocking area NPXA may be an area between neighboring light emitting areas among the light emitting areas PXA-B, PXA-G and PXA-R, and an area corresponding to a pixel defining film PDL (see FIG. 5), which will be described in more detail later. The light emitting area PXA may be an area corresponding to a light emitting element ED (see FIG. 5), which will be described in more detail later.

FIG. 5 is a cross-sectional view schematically illustrating a display module DM according to one or more embodiments of the present invention. FIG. 5 may also be a cross-sectional view illustrating a portion corresponding to the first light emitting area PXA-B and the light blocking area NPXA adjacent to the first light emitting area PXA-B, illustrated in FIG. 4. Hereinafter, the same description about the first light emitting area PXA-B may apply to the second and third light emitting areas PXA-G and PXA-R illustrated in FIG. 4.

Referring to FIG. 5, a base substrate BS may include a single layer or a plurality of layers. For example, in one or more embodiments, the base substrate BS may include a first synthetic resin layer, an inorganic layer having a multilayer or single-layer structure, and a second synthetic resin layer arranged on the inorganic layer having a multilayer or single-layer structure. In one or more embodiments, each of the first synthetic resin layer and the second synthetic resin layer may include a polyimide-based resin. In one or more embodiments, each of the first synthetic resin layer and the second synthetic resin layer may include at least one of an acryl-based resin, a methacryl-based resin, a polyisoprene-based resin, a vinyl-based resin, an epoxy-based resin, a urethane-based resin, a cellulose-based resin, a siloxane-based resin, a polyamide-based resin, or a perylene-based resin. The term "α"-based resin as used herein indicates one including a functional group of "α".

A display panel DP may include a transistor TR and a light emitting element ED. The transistor TR and the light emitting element ED may be arranged on the base substrate BS. Although one transistor TR is illustrated in FIG. 5, the display panel DP may substantially include a plurality of transistors and at least one capacitor for driving the light emitting element ED.

A circuit layer DP-CL may include an insulating layer, a semiconductor pattern, a conductive pattern, a signal line, and/or the like. For example, in one or more embodiments, the circuit layer DP-CL may include switching transistor(s) and driving transistor(s) for driving the light emitting element ED of a display element layer DP-EL.

The circuit layer DP-CL may include a shielding electrode BML, the transistor TR, a connection electrode CNE, and a plurality of insulating layers BFL and INS1 to INS6. The plurality of insulating layers BFL and INS1 to INS6 may include a buffer layer BFL and first to sixth insulating layers INS1 to INS6. However, a stack structure of the circuit layer DP-CL illustrated in FIG. 5 is merely an example, and the stack structure of the circuit layer DP-CL may be changed according to the configuration of the display panel DP and a process of the circuit layer DP-CL and/or the like.

The shielding electrode BML may be arranged on the base substrate BS. The shielding electrode BML may overlap the transistor TR. The shielding electrode BML may protect the transistor TR by blocking light which may be incident on the transistor TR from below the display panel DP. The shielding electrode BML may include a conductive material (e.g., electron conductor). When a voltage is applied to the shielding electrode BML, a threshold voltage of the transistor TR arranged on the shielding electrode BML may be maintained. However, embodiments of the present invention are not limited thereto, for example, in one or more embodiments, the shielding electrode BML may be a floating electrode. In one or more embodiments, the shielding electrode BML may not be provided.

The buffer layer BFL may be arranged on the base substrate BS and cover the shielding electrode BML. The buffer layer BFL may include an inorganic layer. The buffer layer BFL may improve a bonding force between the base substrate BS and a semiconductor pattern or a conductive pattern which is arranged on the buffer layer BFL.

The transistor TR may include a source S1, a channel C1, a drain D1, and a gate G1. The source S1, the channel C1, and the drain D1 of the transistor TR may be provided from the semiconductor pattern. The semiconductor pattern of the transistor TR may include polysilicon, amorphous silicon, or a metal oxide, and as long as having semiconductor properties, the material thereof is unrestrictedly applied and is not limited thereto.

The semiconductor pattern may include a plurality of regions divided according to a magnitude of conductivity. A region of the semiconductor pattern, which is doped with a dopant or in which a metal oxide is reduced, may have high conductivity and may substantially serve as a source electrode or a drain electrode of the transistor TR. The regions of the semiconductor pattern, which have high conductivity, may respectively correspond to the source S1 and the drain D1 of the transistor TR. A region of the semiconductor pattern, which has low conductivity by being non-doped or doped at a low concentration or by a metal oxide being nonreduced, may correspond to the channel C1 (or active) of the transistor TR.

The first insulating layer INS1 may cover the semiconductor pattern of the transistor TR and be arranged on the buffer layer BFL. The gate G1 of the transistor TR may be arranged on the first insulating layer INS1. The gate G1 may overlap the channel C1 of the transistor TR on a plane (e.g., in plan view)). The gate G1 may function as a mask in a process of doping the semiconductor pattern of the transistor TR.

The second insulating layer INS2 may cover the gate G1 and be arranged on the first insulating layer INS1. The third insulating layer INS3 may be arranged on the second insulating layer INS2.

The connection electrode CNE may include a first connection electrode CNE1 and a second connection electrode CNE2 which are provided to electrically connect the transistor TR to the light emitting element ED. However, the components of the connection electrode CNE, which electrically connect the transistor TR to the light emitting element ED, are not limited thereto. In one or more embodiments, one of (e.g., one selected from among) the first and second connection electrodes CNE1 and CNE2 may not be provided, or an additional connection electrode may be further included.

The first connection electrode CNE1 may be arranged on the third insulating layer INS3. The first connection electrode CNE1 may be connected to the drain D1 through a first contact hole CH1 passing through the first to third insulating layers INS1 to INS3. The fourth insulating layer INS4 may cover the first connection electrode CNE1 and be arranged on the third insulating layer INS3. The fifth insulating layer INS5 may be arranged on the fourth insulating layer INS4.

The second connection electrode CNE2 may be arranged on the fifth insulating layer INS5. The second connection electrode CNE2 may be connected to the first connection electrode CNE1 through a second contact hole CH2 passing through the fourth and fifth insulating layers INS4 and INS5. The sixth insulating layer INS6 may cover the second connection electrode CNE2 and be arranged on the fifth insulating layer INS5.

The sixth insulating layer INS6 may be a planarization layer. A top surface of the sixth insulating layer INS6 may be a flat surface. The top surface of the sixth insulating layer INS6 may be adjacent to the display element layer DP-EL, and a bottom surface of the sixth insulating layer INS6 may be a surface spaced and/or apart (e.g., spaced apart or separated) from the display element layer DP-EL with the top surface of the sixth insulating layer INS6 arranged between the bottom surface and the display element layer DP-EL.

Each of the first to sixth insulating layers INS1 to INS6 may independently include an inorganic layer or an organic layer. For example, the inorganic layer may include at least one of aluminum oxide, titanium oxide, silicon oxide, silicon oxynitride, zirconium oxide, or hafnium oxide. The organic layer may include at least one of a acryl-based resin, a methacryl-based resin, a polyisoprene-based resin, a vinyl-based resin, an epoxy-based resin, a urethane-based resin, a cellulose-based resin, a siloxane-based resin, a polyamide-based resin, or a perylene-based resin.

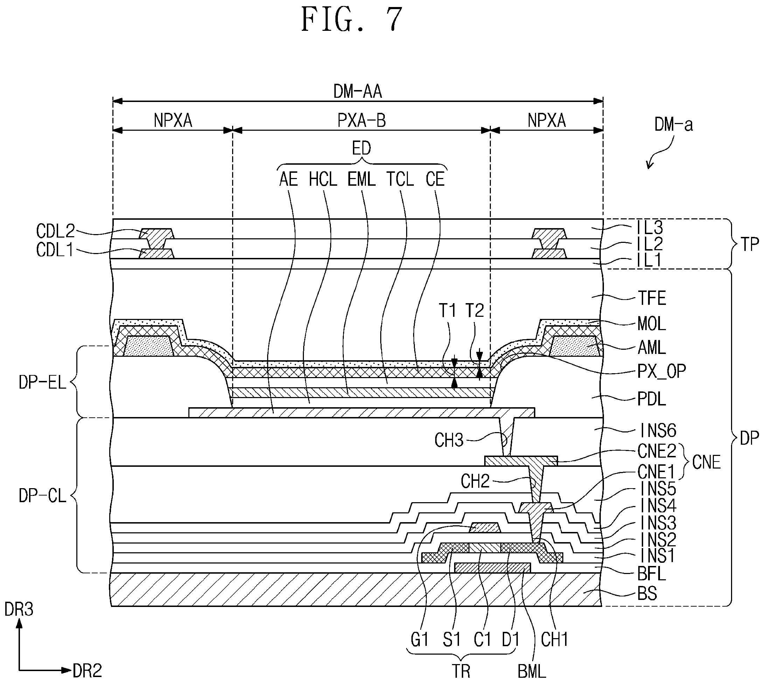

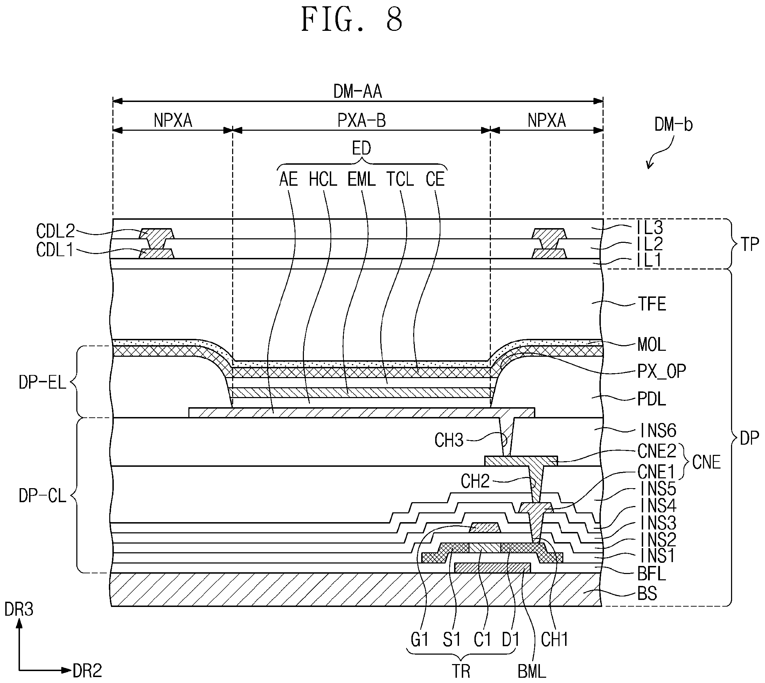

The display element layer DP-EL may include a pixel defining film PDL and the light emitting element ED. In addition, the display element layer DP-EL may include at least one of an auxiliary metal layer AML or a metal oxide layer MOL (see FIG. 7 and FIG. 8).

The light emitting element ED may include a pixel electrode AE, an emission layer EML arranged on the pixel electrode AE, an electron control layer TCL arranged on the emission layer EML, and a transparent electrode CE arranged on the electron control layer TCL. In one or more embodiments, the light emitting element ED may further include a hole control layer HCL arranged between the pixel electrode AE and the emission layer EML.

The light emitting element ED may be to emit light. For example, the light emitting element ED may include an organic light emitting material, an inorganic light emitting material, an organic-inorganic light emitting material, a quantum dot, or a quantum rod. For example, in one or more embodiments, the light emitting element ED may include a micro LED or a nano LED.

The pixel electrode AE may be arranged on the sixth insulating layer INS6. The pixel electrode AE may be connected to the second connection electrode CNE2 through a third contact hole CH3 passing through the sixth insulating layer INS6. The pixel electrode AE may be electrically connected to the drain D1 of the transistor TR through the first and second connection electrodes CNE1 and CNE2.

The pixel electrode AE may include a metal material, a metal alloy, or a conductive compound. The pixel electrode AE may be an anode or a cathode. However, embodiments of the present invention are not limited thereto. The pixel electrode AE may be a transmissive electrode, a semi-transmissive electrode, or a reflective electrode. The pixel electrode AE may include at least one selected from among Ag, Mg, Cu, Al, Pt, Pd, Au, Ni, Nd, Ir, Cr, Li, Ca, LiF, Mo, Ti, W, In, Sn, and Zn, a compound of two or more selected therefrom, a mixture of two or more selected therefrom, or an oxide thereof.

In embodiments in which the pixel electrode AE is a transmissive electrode, the pixel electrode AE may include a transparent metal oxide, for example, indium tin oxide (ITO), indium zinc oxide (IZO), zinc oxide (ZnO), indium tin zinc oxide (ITZO), and/or the like. In embodiments in which the pixel electrode AE is a semi-transmissive electrode or a reflective electrode, the pixel electrode AE may include Ag, Mg, Cu, Al, Pt, Pd, Au, Ni, Nd, Ir, Cr, Li, Ca, LiF/Ca (a stacked structure of LiF and Ca), LiF/Al (a stacked structure of LiF and Al), Mo, Ti, W, or a compound or a mixture thereof (e.g., a mixture of Ag and Mg). In one or more embodiments, the pixel electrode AE may have a multilayer structure including a reflective film or a semi-transmissive film, each of which includes one or more of the foregoing materials, and a transmissive conductive film which includes indium tin oxide (ITO), indium zinc oxide (IZO), zinc oxide (ZnO), indium tin zinc oxide (ITZO), and/or the like. For example, in one or more embodiments, the pixel electrode AE may have a three-layer structure of ITO/Ag/ITO, but embodiments of the present invention are not limited thereto. The pixel electrode AE may include one of the foregoing metal materials, a combination of two or more metal materials selected from among the foregoing metal materials, an oxide of the foregoing metal materials, and/or the like.

The pixel defining film PDL may be arranged on the sixth insulating layer INS6. An opening PX_OP which exposes at least a portion of the pixel electrode AE may be defined in the pixel defining film PDL. The portion of the pixel electrode AE, which is exposed by the opening PX_OP, may be defined as the first light emitting area PXA-B.

An area in which the pixel defining film PDL is arranged may correspond to a light blocking area NPXA. The light blocking area NPXA may be around (e.g., surround) the first light emitting area PXA-B within an active area DM-AA.

The hole control layer HCL may be arranged on the pixel electrode AE. The hole control layer HCL may be arranged in an area corresponding to the opening PX_OP. The hole control layer HCL may have a single layer including a single material, a single layer including a plurality of different materials, or a multilayer structure having a plurality of layers including a plurality of different materials. The hole control layer HCL may include at least one of a hole transport layer, a hole injection layer, or an electron blocking layer. The hole control layer HCL may include a general hole injection material and/or a general hole transport material.

The emission layer EML may be arranged on the hole control layer HCL. In one or more embodiments, the emission layer EML may be arranged in an area corresponding to the opening PX_OP. In one or more embodiments, the emission layer EML may be provided as a common layer. The emission layer EML may include an organic light emitting material and/or an inorganic light emitting material. The emission layer EML may be to emit light of one color among red, green, and blue colors. For example, in one or more embodiments, the emission layer EML of the light emitting element ED corresponding to the first light emitting area PXA-B may be to emit blue light. An emission layer of a light emitting element corresponding to the second light emitting area PXA-G (see FIG. 4) may be to emit green light. An emission layer of a light emitting element corresponding to the third light emitting area PXA-R (see FIG. 4) may be to emit red light.

The electron control layer TCL may be arranged on the emission layer EML. In one or more embodiments, the electron control layer TCL may be arranged in an area corresponding to the opening PX_OP. The electron control layer TCL according to one or more embodiments may function to generate electrons. The electron control layer TCL may include, as an electron generation material, at least one of a metal oxide such as Li₂O, BaO, and/or MgO, a Group 1 metal, a Group 2 metal, a halogenated metal (e.g., a metal halide), a lanthanum group metal (e.g., a lanthanide metal), Li, Mg, Ag, or (8-hydroxyquinolinato)lithium (Liq). The halogenated metal (e.g., metal halide) may be a material obtained by chemically combining a halogen element and a metal. For example, the halogenated metal (e.g., metal halide) may be LiF, NaCl, CsF, RbCl, RbI, Cul, KI, and/or the like. The lanthanum group metal (e.g., lanthanide metal) may be ytterbium (Yb), lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), lutetium (Lu), and/or the like. In one or more embodiments, the electron control layer TCL may include, as an electron generation material, a co-deposition material of the halogenated metal (e.g., metal halide) and the lanthanum group metal (e.g., lanthanide metal). As used herein, the "Group" indicates a group in the International Union of Pure and Applied Chemistry (IUPAC) periodic table according to the 1 to 18 grouping system of the IUPAC.

The electron control layer TCL may have a single layer including a single material, a single layer including a plurality of different materials, or a multilayer structure having a plurality of layers including a plurality of different materials. For example, in one or more embodiments, the electron control layer TCL may include at least one of an electron generation layer, an electron transport layer, an electron injection layer, or a hole blocking layer. The electron control layer TCL may include one or more of the foregoing electron generation materials, and further include a general electron injection material and/or a general electron transport material.

The transparent electrode CE may be arranged on the electron control layer TCL. The transparent electrode CE may be provided as a common layer overlapping the first light emitting area PXA-B and the light blocking area NPXA. The transparent electrode CE may be a common electrode. The transparent electrode CE may be a cathode or an anode, but embodiments of the present invention are not limited thereto. For example, in one or more embodiments, the pixel electrode AE may be an anode, and the transparent electrode CE may be a cathode.

In one or more embodiments, the transparent electrode CE may be a transmissive electrode including gallium. The transparent electrode CE may include a transparent conductive oxide (TCO) including gallium. For example, in one or more embodiments, the transparent electrode CE may be a transmissive electrode including indium gallium zinc oxide (IGZO). The transparent electrode CE may be optically transparent (e.g., with respect to visible light). The transparent electrode CE may be a single layer. For example, in one or more embodiments, the transparent electrode CE may include only indium gallium zinc oxide (IGZO).

The transparent electrode CE may be directly arranged on the electron control layer TCL. The transparent electrode CE may be directly arranged on the electron control layer TCL and protect the components (e.g., the hole control layer HCL, the emission layer EML, and the electron control layer TCL) of the light emitting element ED, arranged below the transparent electrode CE.

In the display panel DP including the transparent electrode CE and the display device DD (see FIG. 2) including the display panel DP, a change in luminance (or color coordinate) according to viewing angles may be minimized or reduced. The display panel DP including the transparent electrode CE may exhibit improved white angle dependency (WAD). The WAD refers to a color shift observed at a side viewing angle, and refers to a phenomenon in which a color of light is differently visible between when a surface from which the light is emitted is viewed from the front and when the surface is viewed from the side. For example, in the phenomenon, when a display surface of a display device which emits white light is viewed from the front, the white light is visible, but when the display surface is viewed from the side, blue or yellow components are partially visible due to light wavelength shift. A display panel including a typical semi-transmissive electrode shows a very significant change in luminance (or color coordinate) according to viewing angles, and accordingly, display quality is decreased. In contrast, the display panel DP and the display device DD (see FIG. 2) including the same may include the transparent electrode CE according to one or more embodiments of the present invention, thereby exhibiting excellent or improved or suitable display quality.

In the transparent electrode CE including indium gallium zinc oxide, generation of foreign matter such as particles may be minimized or reduced (or prevented or reduced) during a manufacture process. The foreign matter such as particles causes a dark spot defect. The transparent electrode CE is generally formed through a deposition process, and a manufacture process for the display panel does not include a cleaning process after a step (e.g., act or task) of forming a cathode (a transparent electrode). Thus, the step (e.g., act or task) of forming the cathode requires minimization in generation of foreign matter. In a case in which a transparent conductive oxide (TCO) such as indium tin oxide (ITO) or indium zinc oxide (IZO) is deposited to form a typical transparent electrode (i.e., the cathode), a relatively large amount of particles are generated. In contrast, in indium gallium zinc oxide, a gallium component in indium gallium zinc oxide may maintain further hardened film quality, thereby minimizing or reducing the generation of foreign matter such as particles. Accordingly, the transparent electrode CE including indium gallium zinc oxide may exhibit excellent or suitable processibility.

In one or more embodiments, the auxiliary metal layer AML may be arranged on the pixel electrode AE. The auxiliary metal layer AML may overlap the light blocking area NPXA but not overlap the first light emitting area PXA-B. In the present invention, if (e.g., when) a component overlaps another component, it refers to that the components overlap with each other on a plane (e.g., in plan view). When a component overlaps another component, it is not limited to a case in which the components have the same surface area and the same shape, and also includes a case in which the components have different surface areas and/or different shapes.

The auxiliary metal layer AML may be arranged between the pixel defining film PDL and the transparent electrode CE. The auxiliary metal layer AML may be directly arranged between the pixel defining film PDL and the transparent electrode CE. The auxiliary metal layer AML may not overlap the pixel electrode AE. The auxiliary metal layer AML may be an auxiliary electrode and be in electrical contact with the transparent electrode CE to reduce resistance of the transparent electrode CE. The auxiliary metal layer AML may be provided to secure lower resistance. The auxiliary metal layer AML may be formed through patterning and be provided in plurality. The auxiliary metal layer AML may include at least one of Al, Ti, Cu, Mo, Ta, Nb, V, Ag, Mg, Pt, Pd, Au, Ni, Nd, Ir, Cr, Li, Ca, Yb, or W. In one or more embodiments, the auxiliary metal layer AML may include an Al alloy or a Mo alloy.

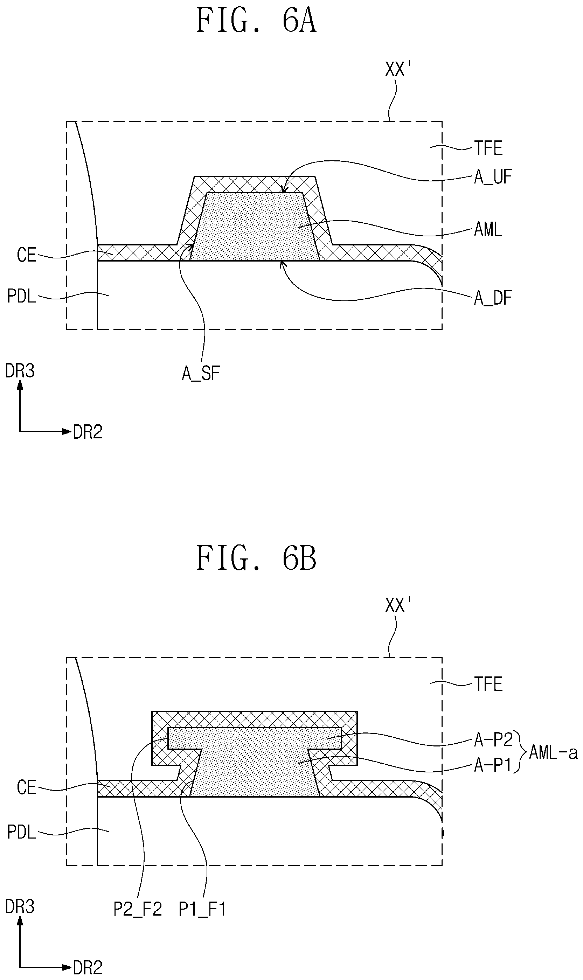

FIG. 6A is an enlarged cross-sectional view illustrating area XX' in FIG. 5 according to one or more embodiments. Referring to FIG. 6A, an auxiliary metal layer AML may include a bottom surface A_DF, a side surface A_SF, and a top surface A_UF. The bottom surface A_DF, the side surface A_SF, and the top surface A_UF may have a shape of one body. The side surface A_SF may extend from the bottom surface A_DF, and the top surface A_UF may extend from the side surface A_SF. The side surface A_SF connects the bottom surface A_DF to the top surface A_UF. The bottom surface A_DF may be spaced and/or apart (e.g., spaced apart or separated) from an encapsulation layer TFE with the top surface A_UF arranged between the bottom surface A_DF and the encapsulation layer TFE. The side surface A_SF may be inclined with respect to the thickness direction DR3 (i.e., the third directional axis DR3). The bottom surface A_DF and the top surface A_UF may be normal (e.g., perpendicular) to the thickness direction DR3. The auxiliary metal layer AML formed through a patterning process may include the side surface A_SF inclined with respect to the thickness direction DR3. The auxiliary metal layer AML formed through the patterning process may have a trapezoidal shape having the side surface A_SF inclined on a cross-section (e.g., in cross-sectional view). The transparent electrode CE may be arranged to be around (e.g., surround) the side surface A_SF of the auxiliary metal layer AML and the top surface A_UF of the auxiliary metal layer AML.

FIG. 6B is an enlarged cross-sectional view illustrating area XX' according to one or more embodiments of the present invention. FIG. 6B may be a cross-sectional view illustrating an auxiliary metal layer AML-a according to one or more embodiments.

Referring to FIG. 6B, the auxiliary metal layer AML-a may include a first portion A-P1, and a second portion A-P2 arranged on the first portion A-P1. In embodiments in which the second portion A-P2 is not included, the auxiliary metal layer AML illustrated in FIG. 6A may be provided. Compared to the auxiliary metal layer AML illustrated in FIG. 6A, the auxiliary metal layer AML-a illustrated in FIG. 6B may further include the second portion A-P2. The first portion A-P1 may be formed through a patterning process, and then the second portion A-P2 may be formed through a deposition process. However, this is merely an example, and methods for forming the first and second portions A-P1 and A-P2 are not limited thereto.

The first portion A-P1 may include a first side surface P1_F1 inclined with respect to the thickness direction DR3 (i.e., the third directional axis DR3). The first side surface P1_F1 may correspond to the side surface A_SF illustrated in FIG. 6A. The second portion A-P2 may include a second side surface P2_F2 parallel to the thickness direction DR3. The second side surface P2_F2 may be arranged outward from the first side surface P1_F1. As the second side surface P2_F2 is arranged outward from the first side surface P1_F1, a tip portion may be defined on the auxiliary metal layer AML-a on a cross-section. The auxiliary metal layer AML-a on which the tip portion is defined may exhibit more excellent or suitable low-resistance characteristics. The auxiliary metal layer AML-a on which the tip portion is defined may connect the transparent electrode CE into an undercut structure. The transparent electrode CE may be arranged to be around (e.g., surround) the tip portion of the auxiliary metal layer AML-a. The transparent electrode CE may be arranged to be around (e.g., surround) the first side surface P1_F1 of the auxiliary metal layer AML-a and the second side surface P2_F2 of the auxiliary metal layer AML-a. However, the shapes of the auxiliary metal layers AML and AML-a illustrated in FIGS. 6A and 6B are mere examples, and embodiments of the present invention are not limited thereto.

Referring to FIG. 5 again, an encapsulation layer TFE may be arranged on the display element layer DP-EL. The encapsulation layer TFE may be arranged on the transparent electrode CE and cover the light emitting element ED. The encapsulation layer TFE may protect the display element layer DP-EL from moisture, oxygen, and/or foreign matter such as dust particles. The encapsulation layer TFE may include a plurality of thin films.

The encapsulation layer TFE may include at least one inorganic film. For example, in one or more embodiments, the encapsulation layer TFE may include inorganic films arranged on the transparent electrode CE, and an organic film arranged between the inorganic films. The inorganic films may protect the light emitting element ED from moisture/oxygen, and the organic film may protect the light emitting element ED from foreign matter such as dust particles. For example, the encapsulation layer TFE may include inorganic films arranged on the transparent electrode CE, and an organic film arranged between the inorganic films.

An input sensing part TP may be arranged on the display panel DP. For example, in one or more embodiments, the input sensing part TP may be directly arranged on the encapsulation layer TFE of the display panel DP. In one or more embodiments, an adhesive layer may be arranged between the input sensing part TP and the display panel DP.

The input sensing part TP may include a first sensing insulating layer IL1, a second sensing insulating layer IL2, and a third sensing insulating layer IL3. The input sensing part TP may include at least one conductive layer arranged on the sensing insulating layers. In one or more embodiments, the input sensing part TP may include a first conductive layer CDL1 and a second conductive layer CDL2.

The first sensing insulating layer IL1 may be arranged on the encapsulation layer TFE. The first sensing insulating layer IL1 may include at least one inorganic insulating layer. The first sensing insulating layer IL1 may be in contact with the encapsulation layer TFE. In one or more embodiments, the first sensing insulating layer IL1 may not be provided, and in these embodiments, the first conductive layer CDL1 may be in contact with the encapsulation layer TFE.

The first conductive layer CDL1 may be arranged on the first sensing insulating layer IL1. The first conductive layer CDL1 may include a plurality of first conductive patterns. The plurality of first conductive patterns may be arranged on the first sensing insulating layer IL1. The second sensing insulating layer IL2 may be arranged on the first sensing insulating layer IL1 so as to cover at least a portion of the first conductive layer CDL1.

The second conductive layer CDL2 may be arranged on the second sensing insulating layer IL2. The second conductive layer CDL2 may include a plurality of second conductive patterns. The plurality of second conductive patterns may be arranged on the second sensing insulating layer IL2. The plurality of second conductive patterns may be respectively connected to the plurality of first conductive patterns through contact holes defined in the second sensing insulating layer IL2.

Each of the plurality of first conductive patterns of the first conductive layer CDL1 and the plurality of second conductive patterns of the second conductive layer CDL2 may be arranged to correspond to the light blocking area NPXA. Each of the plurality of first conductive patterns of the first conductive layer CDL1 and the plurality of second conductive patterns of the second conductive layer CDL2 may be a mesh pattern.

The third sensing insulating layer IL3 may be arranged on the second sensing insulating layer IL2, and may cover the second conductive layer CDL2. Each of the second sensing insulating layer IL2 and the third sensing insulating layer IL3 may include an inorganic insulating layer or an organic insulating layer.

Each of the first conductive layer CDL1 and the second conductive layer CDL2 may have a single-layer structure, or have a multilayer structure in which constituent layers are stacked in the third direction DR3. The conductive layers CDL1 and CDL2 each having a single-layer structure may each include a metal layer or a transparent conductive layer. The metal layer may include molybdenum, silver, titanium, copper, aluminum, or an alloy thereof. The transparent conductive layer may include a transparent conductive oxide such as indium tin oxide (ITO), indium zinc oxide (IZO), zinc oxide (ZnO), and/or indium tin zinc oxide (ITZO). The transparent conductive layer may also include a conductive polymer such as poly(3,4-ethylenedioxythiophene) (PEDOT), a metal nanowire, graphene, and/or the like.

The conductive layers CDL1 and CDL2 each having a multilayer structure may each include metal layers. In one or more embodiments, the metal layers may have, for example, a three-layer structure of titanium (Ti)/aluminum (Al)/titanium (Ti). In one or more embodiments, each of the conductive layers CDL1 and CDL2 having a multilayer structure may include at least one metal layer and at least one transparent conductive layer.

FIGS. 7 to 11 are cross-sectional views illustrating display modules DM-a, DM-b, DM-c, DM-d, and DM-e according to embodiments of the present invention. Hereinafter, embodiments will be described with reference to FIGS. 7 to 11 by not repeating the content in common with the content described with reference to FIGS. 1 to 5, 6A, and 6B, and mainly in terms of differences.

Compared to the display module DM illustrated in FIG. 5, the display module DM-a illustrated in FIG. 7 is different in that the display module DM-a includes a metal oxide layer MOL. A display panel DP of the display module DM-a may include the metal oxide layer MOL.

The metal oxide layer MOL may be arranged on a transparent electrode CE. The metal oxide layer MOL may be directly arranged on the transparent electrode CE. The metal oxide layer MOL may overlap a pixel electrode AE and a pixel defining film PDL. The metal oxide layer MOL may be arranged as a common layer overlapping a first light emitting area PXA-B and a light blocking area NPXA.

The metal oxide layer MOL may be optically transparent. The metal oxide layer MOL may have a transmittance of about 80% or more with respect to light in a visible light wavelength range. The metal oxide layer MOL may include a transparent conductive oxide (TCO) different from a material (i.e., IGZO) of the transparent electrode CE. The metal oxide layer MOL may be provided to secure lower resistance. For example, the metal oxide layer MOL may include a transparent conductive oxide having a specific resistance of about 800 µΩ·cm or less or about 450 µΩ·cm or less.

The metal oxide layer MOL may include indium zinc oxide (IZO) or indium tin oxide (ITO). The metal oxide layer MOL including indium zinc oxide or indium tin oxide may exhibit relatively low resistance.

A first thickness T1 of the transparent electrode CE may be larger than a second thickness T2 of the metal oxide layer MOL. In a case in which the second thickness T2 of the metal oxide layer MOL is larger than the first thickness T1 of the transparent electrode CE, the resistance is increased to decrease display lifespan of the display panel. However, as the second thickness T2 of the metal oxide layer MOL is smaller than the first thickness T1 of the transparent electrode CE, the display panel DP according to one or more embodiments may exhibit excellent or suitable display lifespan.

In one or more embodiments, the second thickness T2 of the metal oxide layer MOL may be about 10 nm (100 Å) to about 50 nm (500 Å). The metal oxide layer MOL having the second thickness T2 of about 10 nm (100 Å) to about 50 nm (500 Å) may exhibit low-resistance characteristics. The first thickness T1 of the transparent electrode CE may be about 40 nm (400 Å) to about 70 nm (700 Å). The transparent electrode CE having the first thickness T1 of about 40 nm (400 Å) to about 70 nm (700 Å) may exhibit good or suitable resistance and protect components of a light emitting element ED arranged below the transparent electrode CE.

Compared to the display module DM illustrated in FIG. 5, the display module DM-b illustrated in FIG. 8 is different in that the display module DM-b does not include an auxiliary metal layer AML but includes a metal oxide layer MOL. Referring to FIG. 8, in a light blocking area NPXA, a transparent electrode CE may be directly arranged on a pixel defining film PDL.

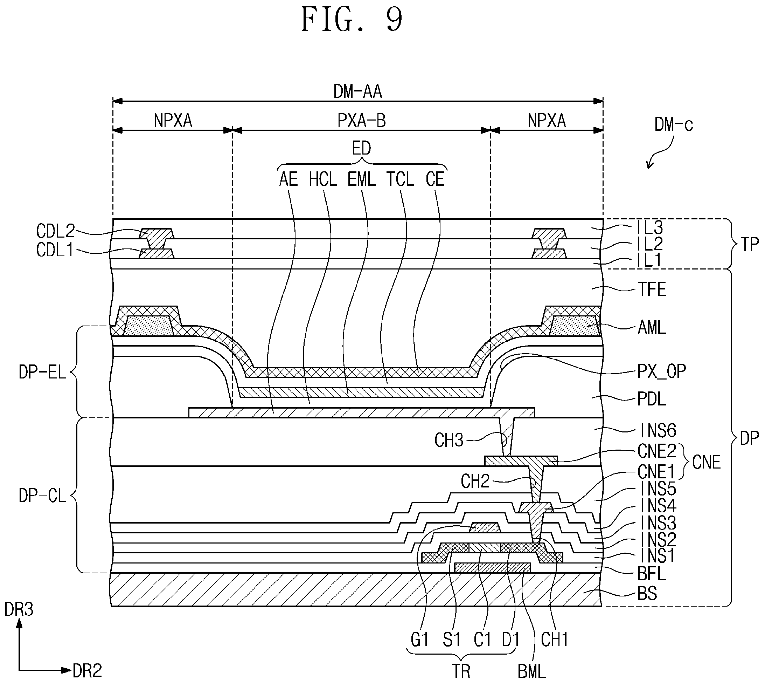

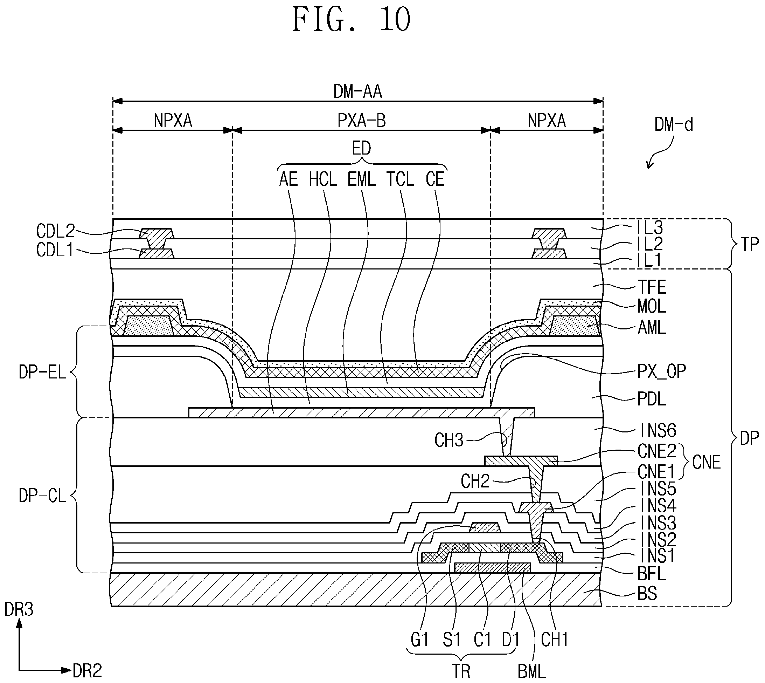

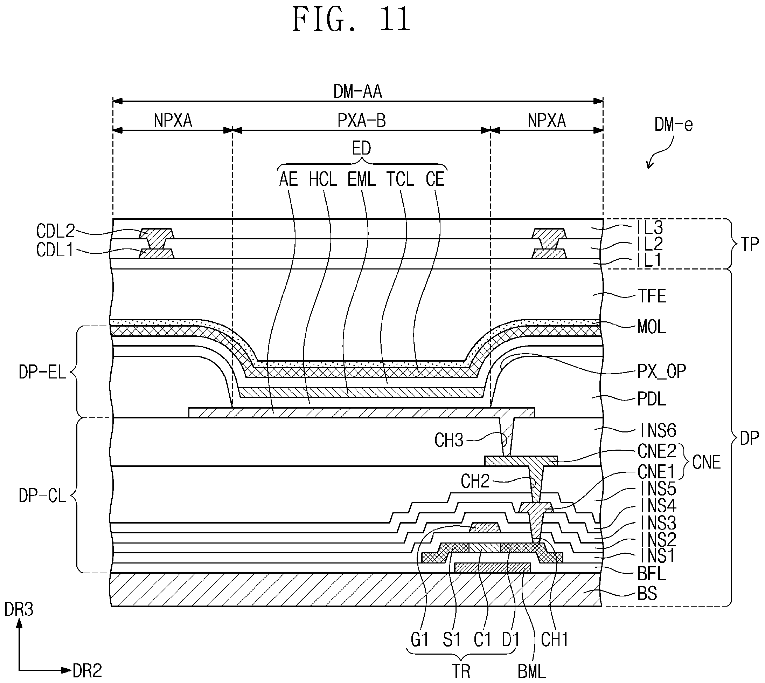

Compared to the display module DM illustrated in FIG. 5, the display module DM-c illustrated in FIG. 9 is different in that each of a hole control layer HCL and an electron control layer TCL is arranged as a common layer. Compared to the display module DM-a illustrated in FIG. 7, the display module DM-d illustrated in FIG. 10 is different in that each of a hole control layer HCL and an electron control layer TCL is arranged as a common layer. Compared to the display module DM-b illustrated in FIG. 8, the display module DM-e illustrated in FIG. 11 is different in that each of a hole control layer HCL and an electron control layer TCL is arranged as a common layer.

Referring to FIGS. 9 to 11, each of the hole control layer HCL and the electron control layer TCL may overlap a first light emitting area PXA-B and a light blocking area NPXA. Each of the hole control layer HCL and the electron control layer TCL may overlap a pixel defining film PDL.

Referring to FIGS. 9 and 10, an auxiliary metal layer AML may be arranged between the electron control layer TCL and a transparent electrode CE. The auxiliary metal layer AML may be directly arranged between the electron control layer TCL and the transparent electrode CE.

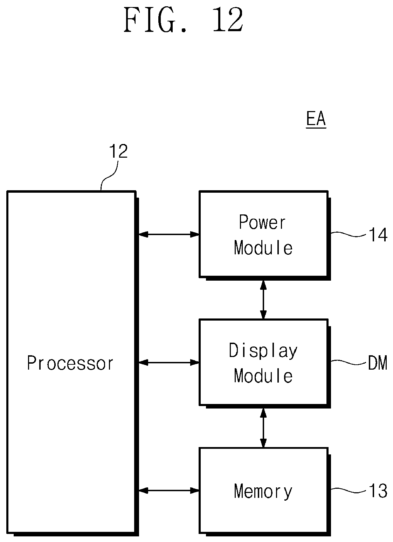

FIG. 12 is a block diagram of an electronic apparatus according to one or more embodiments of the present invention. Referring to FIG. 12, an electronic apparatus EA according to one or more embodiments may include a display module DM, a processor 12, a memory 13, and a power module 14.

The processor 12 may include at least one of a central processing unit (CPU), an application processor (AP), a graphic processing unit (GPU), a communication processor (CP), an image signal processor (ISP), or a controller. The power module 14 may include a power supply module such as a power adapter and/or a battery device, and a power conversion module which converts the power supplied by the power supply module and generates power necessary for an operation of the electronic apparatus EA.

The memory 13 may store data information necessary for an operation of the processor 12 and/or the display module DM. When the processor 12 executes an application stored in the memory 13, an image data signal and/or an input control signal may be transmitted to the display module DM, and the display module DM may process the received signal and output image information through a display screen.

At least one of (e.g., at least one selected from among) components of the electronic apparatus EA may be included in the display module DM according to one or more embodiments. In addition, among the components of the electronic apparatus EA, some of individual modules included as functional in one module may be included in the display device DD (see FIG. 2), and others may be provided separately from the display device DD (see FIG. 2). For example, the display device DD (see FIG. 2) may include the display module DM, and the processor 12, the memory 13, and the power module 14 may be provided not in the display device DD (see FIG. 2) but in another type (kind) of device in the electronic apparatus EA.

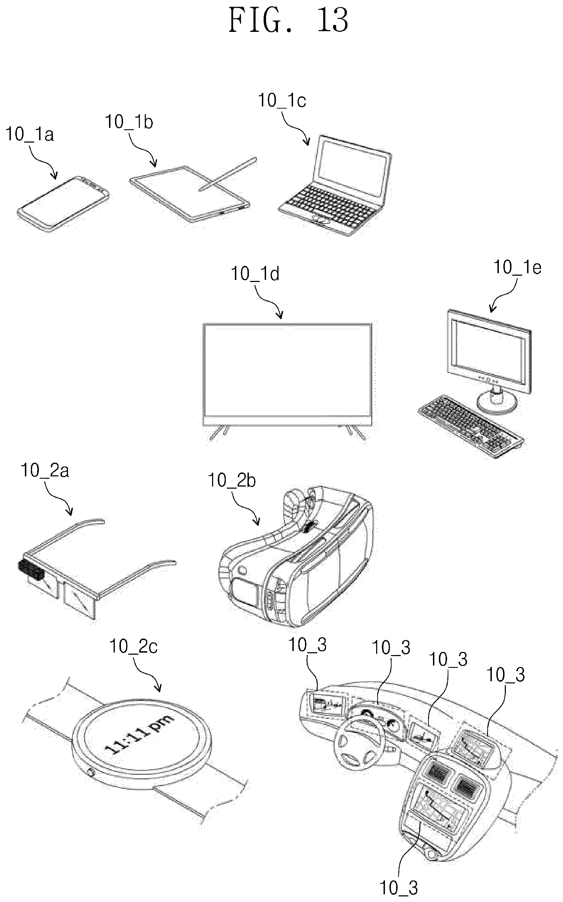

FIG. 13 is a schematic view illustrating electronic apparatuses according to one or more embodiments of the present invention. Referring to FIG. 13, an electronic apparatus EA including the display module DM (see FIG. 3) according to one or more embodiments may include not only electronic apparatuses for displaying images, e.g., a smartphone 10_1a, a tablet computer (PC) 10_1b, a laptop computer 10_1c, TV 10_1d, and a monitor for a desk computer 10_1e, but also wearable electronic apparatuses including display devices, e.g., smart glasses 10_2a, a head mounted display 10_2b, and a smart watch 10_2c, and vehicle electronic apparatuses 10_3 including display devices, e.g., a vehicle instrument panel, a center fascia, a center information display (CID) arranged on a dashboard, and a room mirror display.

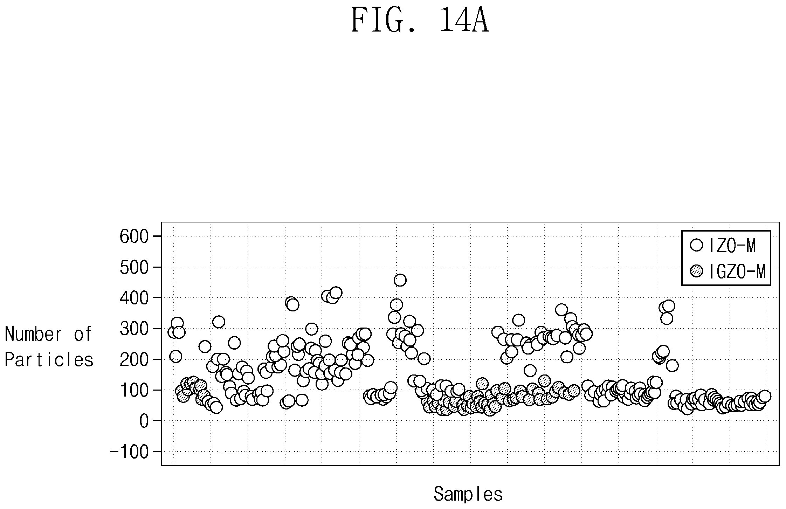

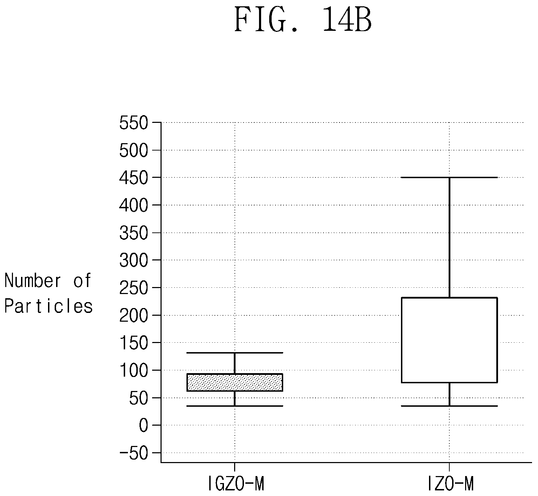

FIG. 14A shows results of measuring the number of particles in a plurality of samples of the present invention. Each of the samples corresponds to a single film formed by providing indium zinc oxide, or a single film formed by providing indium gallium zinc oxide. "IZO-M" corresponds to a single film including indium zinc oxide, and "IGZO-M" corresponds to a single film including indium gallium zinc oxide. Each of the samples corresponds to the single film having a thickness of about 50 nm (500 Å). The particles were measured using an automated optical inspection (AOI) device. In FIG. 14B, distributions of the number of the particles measured in the samples in FIG. 14A are represented in the form of bar graphs.

Referring to FIG. 14A and FIG. 14B, it may be seen that compared to IZO-M, IGZO-M showed a reduction in generation of the particles. For example, the number of the particles detected in the single films (i.e., IGZO-M), each of which was formed by providing indium gallium zinc oxide, is about 75 in average, and the number of the particles detected in the single films (i.e., IZO-M), each of which was formed by providing indium zinc oxide, is about 155 in average. Accordingly, it may be confirmed that in one or more embodiments, a transparent electrode including indium gallium zinc oxide would be minimized or reduced in generation of foreign matter such as particles, and exhibit excellent or suitable processibility.

Table 1 shows results of forming each of indium gallium zinc oxide (IGZO), indium zinc oxide (IZO), and indium tin oxide (ITO) as a single film having a thickness of about 50 nm (500 Å) and evaluating characteristics thereof. In Table 1, "IGZO-M1" corresponds to a single film formed by providing indium gallium zinc oxide, "IZO-M2" corresponds to a single film formed by providing indium zinc oxide, and "ITO-M3" corresponds to a single film formed by providing indium tin oxide.

The single film of indium gallium zinc oxide (IGZO), which exhibits and satisfies the characteristics shown in Table 1, may be applied as a transparent electrode according to one or more embodiments. Each of the single film of indium zinc oxide (IZO) and the single film of indium tin oxide (ITO), which exhibit and satisfy the characteristics shown in Table 1, may be applied as a metal oxide layer according to one or more embodiments.

In Table 1, a refractive index (n) and an extinction coefficient (k) each indicate a value in a wavelength of about 550 nm. According to a relative visibility curve, green light corresponds to light having a high influence on reflectance which decreases display quality of a display device, and the wavelength of about 550 nm corresponds to the green light. When a maximum visibility is 1 and a ratio of a visibility to light having a set or predetermined wavelength (about 380 nm to about 760 nm) is referred to as a relative visibility, a curve representing this relative visibility is the relative visibility curve. In Table 1, the single film including indium gallium zinc oxide (IGZO) exhibits a specific resistance of greater than about 3000 µΩ·cm. The single film including indium gallium zinc oxide (IGZO) underwent deposition (Ar only deposition) under an Ar-only atmosphere.

**Table 1**

| Characteristics | IGZO-M1 | IZO-M2 | ITO-M3 |
|---|---|---|---|
| Refractive Index (n, @ 550 nm) | 2.03 | 2.02 | 2.04 |
| Extinction Coefficient (k, @ 550 nm) | 0.0117 | 0.0123 | 0.035 |
| Transmittance (%) | 85 | 82 | 80 |
| Specific Resistance (µΩ·cm) | > 3000 | 350 | 400 |

Table 2 shows results of measuring a sheet resistance in a display panel including a transparent electrode and including a metal oxide layer and/or an auxiliary metal layer according to one or more embodiments. In Table 2, each of Embodiments 1 to 3 is a display panel according to one or more embodiments.

In Table 2, Embodiment 1 corresponds to the display panel including the transparent electrode and the auxiliary metal layer, as illustrated in FIG. 5. Embodiment 2 corresponds to the display panel including the transparent electrode, the metal oxide layer, and the auxiliary metal layer, as illustrated in FIG. 7. Embodiment 3 corresponds to the display panel including the transparent electrode and the metal oxide layer, as illustrated in FIG. 8.

In Embodiment 1, the transparent electrode is a single layer including indium gallium zinc oxide (IGZO) and having a thickness of about 70 nm (700 Å). In Embodiments 2 and 3, the transparent electrode is a single layer including indium gallium zinc oxide (IGZO) and having a thickness of about 50 nm (500 Å). In Embodiments 1 and 2, Al was patterned to form the auxiliary metal layer. In Embodiments 2 and 3, the metal oxide layer is a layer including indium zinc oxide (IZO) or indium tin oxide (ITO) and having a thickness of about 20 nm (200 Å).

**Table 2**

| | Components | | Sheet Resistance (Ω/□) |
|---|---|---|---|
| Embodiment 1 | Auxiliary Metal Layer | Patterned Al | ≤10 |
| | Transparent Electrode | IGZO, 70 nm (700 Å) | |
| Embodiment 2 | Auxiliary Metal Layer | Patterned Al | ≤10 |
| | Metal Oxide Layer | ITO (or IZO), 20 nm (200 Å) | |
| | Transparent Electrode | IGZO, 50 nm (500 Å) | |
| Embodiment 3 | Metal Oxide Layer | ITO (or IZO), 20 nm (200 Å) | ≤180 |
| | Transparent Electrode | IGZO, 50 nm (500 Å) | |

Referring to Table 2, it may be seen that Embodiments 1 to 3 each including the transparent electrode and also including the metal oxide layer and/or the auxiliary metal layer exhibit good or suitable sheet resistances of about 180 Ω/□ or less or about 10 Ω/□ or less. It may be seen that Embodiments 1 and 2 each including the auxiliary metal layer exhibit the lower sheet resistances. Accordingly, it may be confirm that the display panel including the transparent electrode and also including the metal oxide layer and/or the auxiliary metal layer according to one or more embodiments would exhibit excellent or suitable display efficiency and display lifespan.

In one or more embodiments, an electronic apparatus may include a display panel. The display panel according to one or more embodiments may include a pixel electrode, an emission layer on (e.g., arranged on) the pixel electrode, an electron control layer on (e.g., arranged on) the emission layer, and a transparent electrode on (e.g., arranged on) the electron control layer. The display panel according to one or more embodiments may further include a metal oxide layer and/or an auxiliary metal layer. The transparent electrode may include indium gallium zinc oxide and be directly on (e.g., arranged on) the electron control layer. The metal oxide layer may include indium zinc oxide or indium tin oxide, and be arranged on the transparent electrode. The auxiliary metal layer may include a metal having low-resistance characteristics and be arranged on a pixel defining film. Accordingly, the display panel according to one or more embodiments may exhibit enhanced (e.g., excellent or suitable) processibility, enhanced (e.g., excellent or suitable) display quality, and enhanced (e.g., excellent or suitable) display efficiency. The electronic apparatus including the display panel according to one or more embodiments may exhibit enhanced (e.g., excellent or suitable) processibility.

The display panel and the electronic apparatus including the display panel according to one or more embodiments may include the light emitting element including the transparent electrode including indium gallium zinc oxide, thereby exhibiting the enhanced (e.g., excellent or suitable) processibility and the enhanced (e.g., excellent or suitable) display quality.

For example, the present invention relates to the development and application of organic electroluminescent display devices, focusing on the use of materials such as indium gallium zinc oxide (IGZO), indium zinc oxide (IZO), and/or indium tin oxide (ITO). These materials, when formed into single films, exhibit specific characteristics such as refractive index, extinction coefficient, transmittance, and specific resistance, which are important for their application as transparent electrodes and metal oxide layers. The embodiments demonstrate that incorporating these materials into display panels, along with auxiliary metal layers, results in improved sheet resistance, display efficiency, and lifespan. The electronic apparatuses featuring these display panels exhibit excellent processability, display quality, and efficiency, making them suitable for suitable image display applications.

The utilization of "may" when describing embodiments of the present invention refers to "one or more embodiments of the present invention."

As utilized herein, the terms "substantially," "about," or similar terms are used as terms of approximation and not as terms of degree, and are intended to account for the inherent deviations in measured or calculated values that would be recognized by those of ordinary skill in the art. "About" as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, or 5% of the stated value.

In the context of the present application and unless otherwise defined, the terms "use," "using," and "used" may be considered synonymous with the terms "utilize," "utilizing," and "utilized," respectively.

Any numerical range recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in this specification is intended to include all higher numerical limitations subsumed therein. Accordingly, Applicant reserves the right to amend this specification, including the claims, to expressly recite any subrange subsumed within the ranges expressly recited herein.

The light-emitting element, the display apparatus/device, the electronic apparatus/device, the manufacturing apparatuses thereof, or any other relevant apparatuses/devices or components according to embodiments of the present invention described herein may be implemented utilizing any suitable hardware, firmware (e.g., an application-specific integrated circuit), software, or a combination of software, firmware, and hardware. For example, the various components of the device may be formed on one integrated circuit (IC) chip or on separate IC chips. Further, the various components of the device may be implemented on a flexible printed circuit film, a tape carrier package (TCP), a printed circuit board (PCB), or formed on one substrate. Further, the various components of the device may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the embodiments of the present invention.

In the present invention, each suitable feature of the various embodiments of the invention may be combined or combined with each other, partially or entirely, and may be technically interlocked and operated in various suitable ways, and each embodiment may be implemented independently of each other or in conjunction with each other in any suitable manner unless otherwise stated or implied.

In the above, description has been made with reference to one or more embodiments of the invention, but those skilled or of ordinary skill in the art may understand that one or more suitable modifications and changes may be made to the invention insofar as such modifications and changes do not depart from the technical scope of the invention set forth in the appended claims.

Therefore, the technical scope of the invention is not to be limited to the content stated in the detailed description of the invention, but should be determined by the appended claims.

## Claims

1. A display panel (DP) comprising:
an insulating layer (INS6);
a pixel defining film (PDL) on the insulating layer (INS6) and comprising an opening (PX_OP);
a pixel electrode (AE) having at least a portion exposed through the opening (PX_OP);
an emission layer (EML) on the pixel electrode (AE); and
a transparent electrode (CE) on the emission layer (EML) and comprising gallium,
wherein the display panel (DP) further comprises
a metal oxide layer (MOL) on the transparent electrode (CE) and/or an auxiliary metal layer (AML) on the pixel defining film (PDL).

2. The display panel (DP) of claim 1, wherein the transparent electrode (CE) comprises indium gallium zinc oxide.

3. The display panel (DP) of claim 1 or 2, further comprising an electron control layer (TCL) on the emission layer (EML),
wherein the transparent electrode (CE) is directly on the electron control layer (TCL).

4. The display panel (DP) of claim 3, wherein the auxiliary metal layer (AML) is between the electron control layer (TCL) and the transparent electrode (CE).

5. The display panel (DP) of claim 3 or 4, wherein the electron control layer (TCL) comprises at least one of Li₂O, BaO, MgO, a metal halide, a lanthanide metal, Li, Mg, Ag, or (8-hydroxyquinolinato)lithium.

6. The display panel (DP) of at least one of claims 1 to 5, wherein the metal oxide layer (MOL) comprises indium zinc oxide or indium tin oxide.

7. The display panel (DP) of at least one of claims 1 to 6, wherein the metal oxide layer (MOL) overlaps the pixel defining film (PDL) and the pixel electrode (AE).

8. The display panel (DP) of at least one of claims 1 to 7, wherein a first thickness (T1) of the transparent electrode (CE) is larger than a second thickness (T2) of the metal oxide layer (MOL),
wherein the first thickness (T1) of the transparent electrode (CE) is about 40 nm to about 70 nm, and
wherein the second thickness (T2) of the metal oxide layer (MOL) is about 10 nm to about 50 nm.

9. The display panel (DP) of at least one of claims 1 to 8, wherein the auxiliary metal layer (AML) comprises at least one of Al, Ti, Cu, Mo, Ta, Nb, V, Ag, Mg, Pt, Pd, Au, Ni, Nd, Ir, Cr, Li, Ca, Yb, or W, and
wherein the auxiliary metal layer (AML) is in electrical contact with the transparent electrode (CE).

10. The display panel (DP) of claim 1 or 2, wherein the auxiliary metal layer (AML) is between the pixel defining film (PDL) and the transparent electrode (CE).

11. The display panel (DP) of at least one of claims 1 to 10, wherein the auxiliary metal layer (AML) does not overlap the pixel electrode (AE).

12. The display panel (DP) of at least one of claims 1 to 11, wherein, on a cross-section parallel to a thickness direction (DR3) of the display panel (DP), the auxiliary metal layer (AML) comprises a side surface (A_SF) inclined with respect to the thickness direction (DR3), and a top surface (A_UF) extending from the side surface (A_SF) and normal to the thickness direction (DR3).

13. The display panel (DP) of at least one of claims 1 to 11, wherein, on a cross-section parallel to a thickness direction (DR3) of the display panel (DP), the auxiliary metal layer (AML-a) comprises a first portion (A-P1) which comprises a first side surface (P1_F1) inclined with respect to the thickness direction (DR3), and a second portion (A-P2) which comprises a second side surface (P2_F2) parallel to the thickness direction (DR3), the second portion (A-P2) being on the first portion (A-P1), and
wherein the second side surface (P2_F2) is arranged outward from the first side surface (P1_F1).

14. An electronic apparatus (EA) comprising:
a display panel (DP) according to at least one of claims 1 to 13 comprising a module area (DM-MH); and
an electronic module (ELM) arranged to correspond to the module area (DM-MH).

15. An electronic apparatus (EA) comprising a processor (12) and a display panel (DP) according to at least one of claims 1 to 13.
